# FASCICULE DE BREVET EUROPEEN

(11) **EP 1 825 454 B1**
(45) Date de publication et mention de la délivrance du brevet: **08.09.2010**
(21) Numéro de dépôt: 05804950.3
(22) Date de dépôt: 10.11.2005
(51) Int. Cl.: G09G 3/28

(54) **CIRCUIT DE DECHARGE D'UNE CHARGE ELECTRIQUE, ET ETAGE DE SORTIE DE PUISSANCE COMPRENANT UN TEL CIRCUIT DE DECHARGE POUR LA COMMANDE DE CELLULES D'ECRAN PLASMA**
SCHALTUNG ZUM ENTLADEN EINER ELEKTRISCHEN LAST UND EINE SOLCHE ENTLADUNGSSCHALTUNG UMFASSENDE LEISTUNGSAUSGANGSSTUFE ZUR STEUERUNG VON PLASMA-ANZEIGEZELLEN
CIRCUIT FOR DISCHARGING AN ELECTRICAL LOAD AND POWER OUTPUT STAGE COMPRISING ONE SUCH DISCHARGE CIRCUIT FOR CONTROLLING PLASMA DISPLAY CELLS

(30) Priorité: 18.11.2004 FR 0412216
(43) Date de publication de la demande: 29.08.2007
(73) Titulaire: STMicroelectronics SA, F-92120 Montrouge (FR)
(72) Inventeur: RAVATIN, François, F-38140 La Murette (FR); TROUSSEL, Gilles, F-38000 Grenoble (FR)
(74) Mandataire: Brungard, Yves Francois
(86) Numéro de dépôt international: PCT/FR2005/002801
(87) Numéro de publication internationale: WO 2006/053966

(56) Documents cités:
- EP-A- 1 087 364
- WO-A-88/08228
- FR-A- 2 763 735
- US-A- 4 779 013

## Description

L'invention concerne un circuit de décharge comprenant un circuit de sortie dont une sortie est connectée à une charge électrique, par exemple de type capacitif, pour absorber un courant de décharge fourni par la charge lorsqu'un signal logique commande une décharge de la charge. L'invention est notamment intéressante pour la réalisation d'étages de sortie de puissance pour la commande de circuits haute tension, tels que par exemple des cellules d'écrans plasma.

Un écran à plasma est un écran de type matriciel formé de cellules disposées aux intersections de lignes et de colonnes. Une cellule comprend une cavité remplie d'un gaz rare, deux électrodes de commande et un dépôt de phosphore rouge, vert ou bleu. Pour créer un point lumineux sur l'écran en utilisant une cellule donnée, on applique une différence de potentiel entre les électrodes de commande de cette cellule, de sorte à déclencher une ionisation de son gaz. Cette ionisation s'accompagne d'une émission de rayons ultraviolets. La création du point lumineux est obtenue par excitation du phosphore déposé, par les rayons émis.

La commande des cellules, en vue de créer des images, est réalisée, classiquement, par des circuits logiques produisant des signaux de commande. Les états logiques de ces signaux déterminent les cellules qui sont commandées pour produire un point lumineux et celles qui sont commandées pour ne pas en produire. Ces circuits logiques sont généralement alimentés en basse tension, par exemple avec une tension de 5V ou moins. Cette tension n'est pas suffisante pour piloter directement les électrodes des cellules. Entre les circuits logiques et les cellules à commander, on utilise donc des étages de sortie de puissance, pour convertir les signaux de commande basse tension en signaux de commande haute tension.

L'ionisation du gaz des cavités nécessite l'application de potentiels élevés sur les électrodes de commande, de l'ordre de grandeur de la centaine de volts. D'autre part, il est nécessaire de pouvoir fournir aux électrodes (et corrélativement de pouvoir recevoir de ces électrodes) des courants importants, de l'ordre de plusieurs dizaines de milliampères. En effet, les électrodes peuvent être représentées, schématiquement par des condensateurs équivalents de capacités relativement élevées de l'ordre de la centaine de picofarad (et corrélativement par des sources de courant de quelques dizaines de milliampères). La commande de ces électrodes est donc équivalente à la commande de charge ou de décharge d'un condensateur.

On souhaite généralement dans les écrans à plasma obtenir des signaux (courants, tensions) qui ont des fronts raides. Cela représente par exemple des durées de charge ou de décharge de l'ordre de la centaine de nanosecondes. Compte tenu du potentiel élevé à atteindre et de l'importance de la charge capacitive, cela suppose que l'on puisse fournir des courants de charge et absorber des courants de décharge très importants, pouvant atteindre la centaine de milliampères.

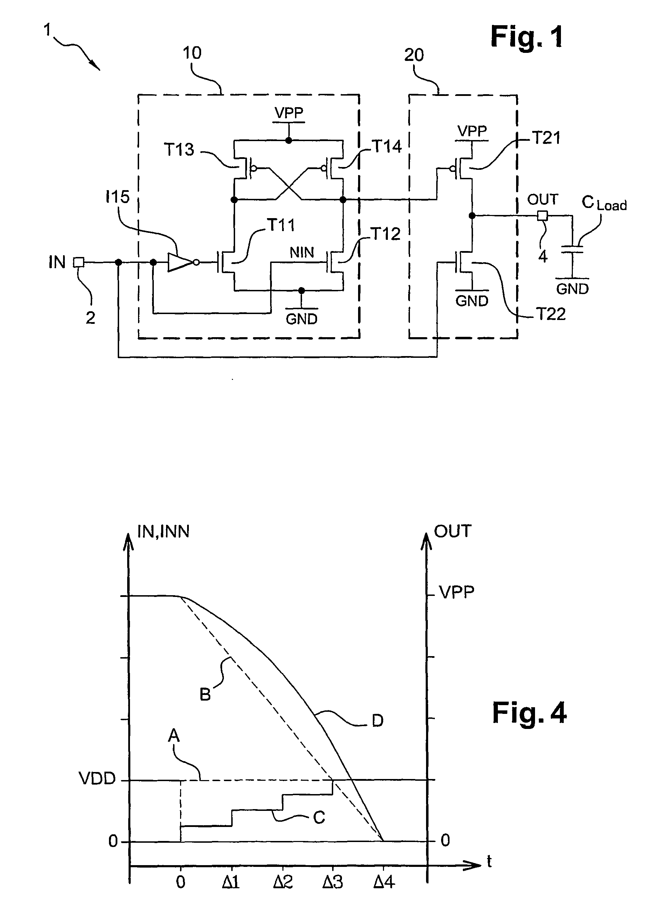

La figure 1 illustre un exemple de réalisation classique d'un étage de sortie permettant de commander une électrode schématisée par un condensateur CLoad. L'étage comprend pour l'essentiel un circuit élévateur de potentiel 10 et un circuit de sortie 20. Le circuit 10 a pour fonction de transformer un signal IN de commande logique basse tension en un signal INP de commande logique haute tension, variant entre 0 et une haute tension VPP et suivant les variations du signal IN. Le circuit 20 comprend un transistor T21 de type P de charge et un transistor T22 de type N de décharge du condensateur CLoad. Le transistor T21 est piloté par le signal INP de commande haute tension : lorsqu'il est passant, le transistor T21 fournit à la charge CLoad un courant de charge, qui va entraîner une élévation du potentiel OUT jusqu'à VPP. Le transistor T22 est piloté par le signal IN de commande basse tension : lorsqu'il est passant, le transistor fournit à la charge CLoad un courant de décharge proportionnel au potentiel du signal IN et le potentiel OUT décroît selon une pente proportionnelle au courant de décharge. Le circuit de la figure 1 est décrit plus longuement dans le document D1 = FR 2 763 735.

Outre la taille excessive du transistor T22 et surtout celle du transistor T21, un inconvénient du circuit de la figure 1 est le risque de conduction simultanée des transistors T21, T22, risque qui entraîne une dissipation importante, compte-tenu des valeurs de tension et de courant présents dans le circuit.

Un autre inconvénient encore du circuit de la figure 1 est les perturbations électromagnétiques qu'il engendre au niveau des cellules de l'écran plasma. En effet, comme on l'a vu précédemment, les tensions et courants mis en jeu sont importants et ils varient dans des proportions importantes sur des laps de temps très brefs lors des changements d'état du signal de commande. Ces variations brutales et d'amplitudes importantes des tensions et courants entraînent des rayonnements électromagnétiques qui perturbent les cellules de l'écran plasma.

D1 propose également une autre structure d'étage de sortie qui permet de diminuer la surface nécessaire au transistor de charge T21 et surtout d'éviter la conduction simultanée des transistors T21, T22 lors des changements d'état du signal de commande. Pour cela, le transistor de charge T21 est remplacé par un circuit de charge comprenant un transistor de type N piloté par un circuit de commande comprenant deux transistors et une diode; le circuit de charge a un fonctionnement est similaire à celui du transistor de type PMOS qu'il remplace. Si la taille du transistor de type N est diminué par rapport à celle du transistor T21 de la figure 1, la taille globale du circuit de charge est sensiblement plus importante. Le transistor de décharge est cette fois un transistor de type DMOS qui a l'avantage d'avoir des temps de blocage ou de mise en conduction particulièrement courts, mais qui par contre est beaucoup plus volumineux et nécessite en plus des inverseurs de commande (pour introduire des retards sur les signaux de commande, retards nécessaires pour éviter la mise en conduction simultanée du circuit de charge et du transistor DMOS), ce qui augmente encore la taille globale du circuit de sortie. Ce circuit n'apporte pas non plus de solution pour limiter les perturbations électromagnétiques engendrées par les changements d'état du signal IN de commande. <page 4a>

L'invention propose une alternative aux circuits de sortie connus, qui limite les rayonnements électromagnétiques susceptibles de perturber des circuits avals tels que les cellules d'un écran plasma, et qui de plus consomme peu d'énergie, et est de taille limitée.

De même que les circuits antérieurs, le circuit de décharge selon l'invention comprend un circuit de sortie dont une sortie est connectée à une charge électrique pour absorber un courant de décharge fourni par la charge lorsqu'un signal logique IN commande une décharge de la charge.

Le circuit de décharge selon l'invention comprend également un circuit de commande pour fournir au circuit Le document US 4,779,013 montre un circuit de décharge comportant plusieurs transistors de décharge en parallèle. Ces transistors sont rendus passant successivement afin d'augmenter progressivement la capacité de décharge. de sortie un signal de commande approprié pour qu'une pente d'un potentiel de sortie du circuit de sortie diminue progressivement lorsque le signal logique commande une décharge de la charge <page 5a>,

Ainsi, avec le circuit de commande selon l'invention, la pente du potentiel de sortie diminue progressivement lentement. Contrairement aux circuits de sortie connus tels que celui de D1 où la pente varie brutalement lorsque le signal logique commande une décharge de la charge puis reste constant.

Les rayonnements électromagnétiques dans les circuits de sortie de l'art antérieur sont essentiellement produits par les changements brusques et importants de la pente du potentiel de sortie ; le circuit selon l'invention permet donc de limiter les rayonnements électromagnétiques en limitant l'amplitude des variations de la pente du potentiel de sortie.

De préférence, le circuit de décharge selon l'invention comprend des moyens pour augmenter progressivement et lentement un potentiel du signal de commande lorsque le signal logique est actif. Ceci permet de limiter les variations de la pente du potentiel de sortie, dans la mesure où la pente du potentiel de sortie est proportionnelle au potentiel du signal de commande, comme on le verra mieux par la suite dans des exemples.

L'invention concerne également un étage de sortie de puissance, pour la commande d'une charge électrique, l'étage de sortie comprenant un circuit de charge pour fournir à la charge un courant de charge lorsqu'un signal logique commande une charge de la charge.

Selon l'invention, l'étage de sortie de puissance comprend également un circuit de décharge tel que décrit ci-dessus.

**, caractérisé en ce que** le circuit de commande comprend des moyens pour augmenter progressivement un potentiel du signal de commande lorsque le signal logique IN est actif , lesdits moyens comprenant N branches connectées en parallèle, N étant un nombre entier supérieur ou égal à 2, chaque branche de rang n comprenant un générateur de potentiel de rang n apte à produire un potentiel VDDn de rang n, les potentiels VDDn de chaque branche étant fournis comme signal de commande successivement dans un ordre croissant lorsque le signal logique d'entrée IN est actif.

L'invention concerne enfin un écran de visualisation comprenant au moins une cellule de type capacitif pour créer un point lumineux sur l'écran, et un circuit d'adressage pour produire un signal logique de commande de la cellule. L'écran selon l'invention comprend également un étage de sortie tel que décrit ci-dessus, pour commander la cellule à partir du signal logique de commande.

L'écran est par exemple du type écran plasma ou écran plat.

L'invention sera mieux comprise et d'autres caractéristiques et avantages apparaîtront à la lecture de la description qui va suivre, d'un exemple de mise en oeuvre d'un circuit de décharge et d'un étage de sortie de puissance selon l'invention. La description est à lire en relation aux dessins annexés dans lesquels :
- la figure 1, déjà décrite, illustre un étage de sortie connu,
- la figure 2 illustre une réalisation d'un étage de sortie selon l'invention,
- la figure 3 montre une version améliorée d'un circuit de commande pour un étage de sortie selon la figure 2, et
- la figure 4 montre l'évolution en fonction du temps du potentiel en sortie du circuit de commande de la figure 3.

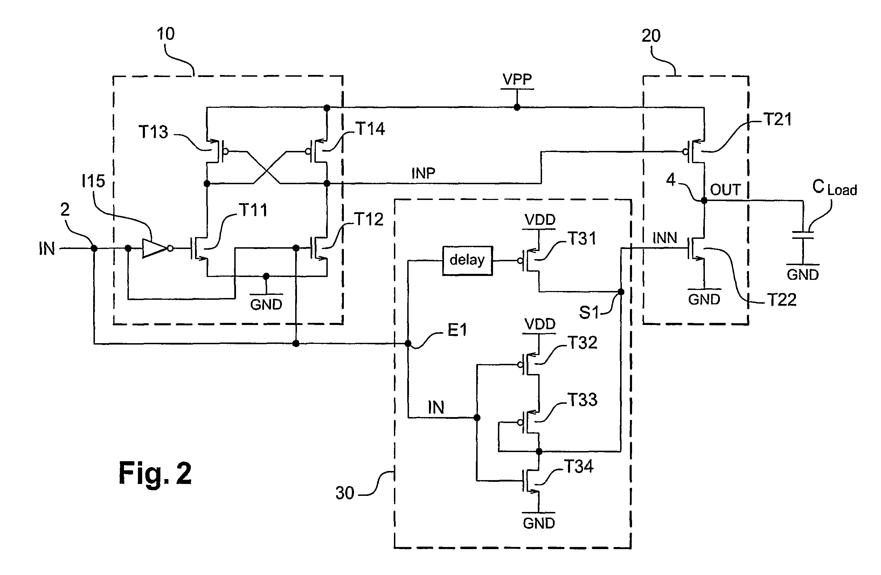

L'étage de sortie de la figure 2 comprend un élévateur de tension 10, un circuit de sortie 20 et un circuit de commande 30 ; l'étage de sortie reçoit un signal logique d'entrée IN sur une entrée 2 et produit un potentiel OUT à une charge capacitive CLoad connectée à sa sortie 4. Le circuit 20 est destiné à charger la charge CLoad lorsque IN est inactif (ici égal à un "1" logique) et à décharger la charge CLoad lorsque IN est actif, ici égal à un "0" logique.

L'étage de sortie reçoit un potentiel d'alimentation VDD basse tension, par exemple de l'ordre de 5 V, un potentiel d'alimentation VPP haute tension, par exemple de l'ordre de 70 à 120 V, et un potentiel de référence GND, correspondant à une masse du circuit.

Le signal logique d'entrée IN est un signal logique basse tension, prenant deux valeurs logiques "0" ou "1", correspondant respectivement au potentiel GND et au potentiel VDD. Le circuit élévateur de potentiel 10 et le circuit de sortie de sortie 20 sont identiques à ceux de la figure 1.

Le circuit 10 a pour fonction d'élever le potentiel du signal logique d'entrée IN, et de produire un signal logique haute tension INP qui suit les variations du signal IN :
- INP = VPP lorsque IN = GND ("0" logique)
- INP = GND lorsque IN = VDD ("1" logique)

Le circuit 20 de sortie comprend un transistor de charge T21, de type P et un transistor de décharge T22 de type N. Le transistor de charge T21 est commandé par le signal INP de commande haute tension ; il permet de fournir un courant de charge sur la sortie 4, pour amener le potentiel de sortie OUT sensiblement au niveau du potentiel VPP en chargeant le condensateur CLoad.

Le transistor de décharge T22 est commandé par un signal de commande basse tension INN ; T22 permet d'absorber un courant de décharge fourni par la charge CLoad sur la sortie 4, pour amener le potentiel de sortie OUT sensiblement au niveau du potentiel de référence GND. Le courant de décharge est proportionnel au potentiel du signal INN sur la grille de T22.

Le circuit de commande 30 reçoit le signal logique d'entrée IN et produit en fonction de ce signal IN le signal de commande basse tension INN, approprié pour que une pente du potentiel de sortie OUT diminue progressivement lorsque le signal IN commande une décharge de la sortie (c'est-à-dire IN actif à 0). La pente du potentiel de sortie est limitée. Pour cela, le circuit 30 produit un signal INN qui varie progressivement entre 0 et VDD lorsque IN passe de 1 (VDD) à 0 (GND), de sorte que les variations du signal INN ont une pente limitée.

Le circuit de commande 30 comprend dans l'exemple de la figure 2 deux branches connectées en parallèle entre l'entrée E1 du circuit 30 sur laquelle est appliqué le signal IN, et la sortie S1 du circuit 30 sur laquelle est produit le signal INN.

La première branche comprend deux transistors T32, T33 de type P et un transistor T34 de type N. Le potentiel VDD est appliqué sur la source de T32 dont le drain est connecté à la source de T33. T33 est monté en diode ; il a une grille connectée à son drain, à la sortie S1 du circuiT 30 et au drain de T34 dont la source est connectée à la masse du circuit (potentiel GND). T33 forme un circuit de chute de potentiel : il reproduit sur sa sortie (= le drain de T33) le potentiel qu'il reçoit sur son entrée (= la source de T33) diminué d'une valeur VC. L'ensemble comprenant les transistors T32, T33, T34 forme un générateur de potentiel commandé par le signal IN, qui produit :
- GND si IN = VDD
- VDD - VC si IN = 0

La deuxième branche comprend, associés en série :
- un circuit de retard Delay1, qui reproduit sur sa sortie le signal IN qu'il reçoit sur son entrée mais décalé d'un temps Δ1.
- un transistor T31 de type P, ayant un drain connecté à la sortie S1, une grille connectée à la sortie du circuit Delay1 et une source sur laquelle est appliqué le potentiel VDD. T31 forme un générateur d'un potentiel égal à VDD, commandé par le signal logique produit par le circuit Delay1.

Le fonctionnement du circuit 30 est le suivant.

Lorsque le signal IN appliqué sur l'entrée E1 passe de GND ("0" logique) à VDD ("1" logique), le transistor T34 devient rapidement passant et amène le signal INN au potentiel GND. Si le transistor T31 est passant, le courant qui circule dans son canal s'écoule vers la masse par l'intermédiaire du transistor T34. Au bout du temps Δ1 introduit par le circuit Delay1, le signal sur la grille de T31 passe à VDD et le transistor T31 se bloque.

Inversement, lorsque le signal IN passe de VDD à GND, le transistor T34 se bloque et le transistor T32 devient passant rapidement (temps de basculement des transistors de l'ordre de 10 à 55 ns). T33 devient également passant, un courant circule dans les transistors T32, T33 et le potentiel INN sur le drain de T33 est tiré vers VDD - VC, où VDD est le potentiel sur la source de T32 et VC est une chute de potentiel introduite par le transistor T33 monté en diode. VC est par exemple de l'ordre de 2 V pour VDD de l'ordre de 5 V. Puis, au bout du temps Δ1 introduit par le circuit Delayl, le signal sur la grille du transistor T31 passe également à GND et le transistor T31 devient passant. Le courant circulant dans T32 tire alors le potentiel du point S1 à VDD.

En résumé :
- lorsque le signal IN passe de GND à VDD, le signal INN passe rapidement de VDD à GND par l'action du transistor T34, et
- lorsque le signal IN passe de VDD à GND, le signal INN passe rapidement de GND à VDD - VC, puis à VDD au bout du temps Δ1.

Ainsi, lorsque IN passe de VDD à GND, le signal INN passe de GND à VDD progressivement en deux étapes, et passe pendant le temps Δ1 par un palier de potentiel intermédiaire égal à VDD - VC.

Le fonctionnement global de l'étage de sortie est le suivant.

Lorsque le signal IN passe de GND à VDD :
- le signal INN passe de VDD à GND et bloque le transistor T22,
- le signal INP passe de VPP à GND et rend passant le transistor T21, qui fournit un courant de charge au condensateur CLoad : le potentiel OUT grimpe progressivement à la valeur VPP.

Lorsque le signal IN passe de VDD à GND :
- le signal INP passe de GND à VPP et bloque le transistor T21,
- le signal INN passe de GND à VDD - VC, puis à VDD au bout du temps Δ1.

Le signal INN non nul rend passant le transistor T22 qui absorbe un courant de décharge du condensateur CLoad, proportionnel au potentiel du signal INN. La décharge du condensateur entraîne une diminution du potentiel OUT selon une pente proportionnelle au courant de décharge et donc proportionnelle au potentiel du signal INN.

Ainsi :
- au début, pendant le temps Δ1, le signal INN est au potentiel VDD - VC : le potentiel au point OUT va donc décroître selon une première pente P1 proportionnelle à VDD - VC, • au bout du temps Δ1, le signal INN passe au potentiel VDD : le potentiel OUT va décroître selon une deuxième pente P2 proportionnelle à VDD et donc supérieure à la première pente P1.

Ainsi, avec le circuit 30 de commande selon l'invention, la pente du potentiel OUT varie progressivement (et non pas brutalement comme dans les circuits de l'art antérieur), en deux étapes, selon deux pentes : une première pente P1 faible puis une deuxième pente P2 plus forte. On limite ainsi l'amplitude des changements de courbure du potentiel du signal OUT. Dit autrement, le circuit 30 de commande selon l'invention permet de lisser la courbe de décharge du condensateur, ce qui va limiter les perturbations électromagnétiques au niveau de la charge en aval (condensateur, écran plasma, etc.).

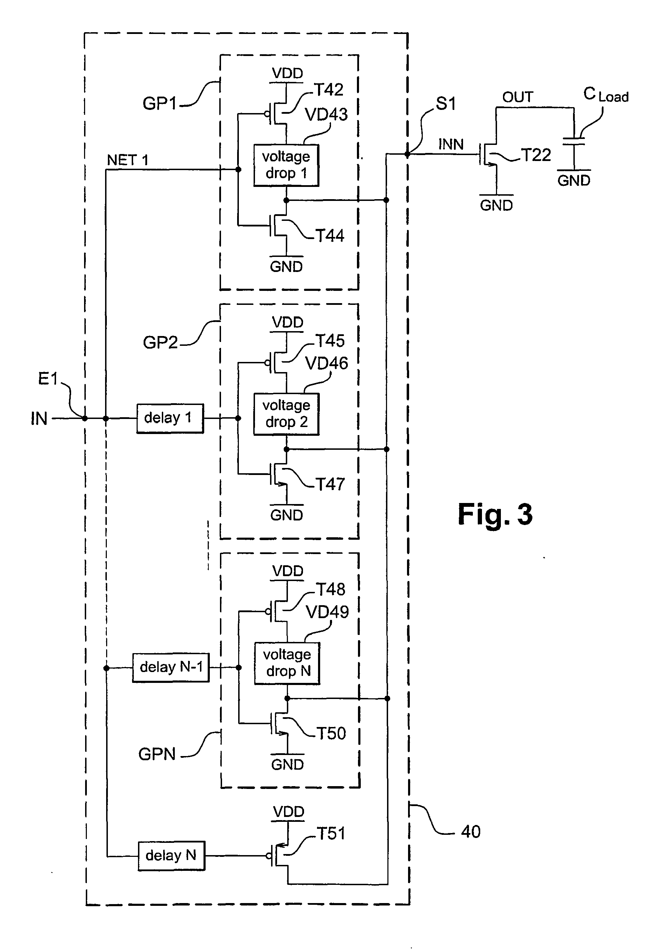

La figure 3 présente une version améliorée du circuit de commande de la figure 2, qui permet de lisser encore plus les variations de la courbe de décharge du condensateur CLoad, et donc de limiter encore plus les perturbations électromagnétiques au niveau de la charge CLoad. Sur la figure 3 sont également représentés le condensateur CLoad et le transistor de charge T22 du circuit de sortie (incomplet).

Le circuit 40 de commande de la figure 3 comprend N+1 branches connectées en parallèle entre l'entrée E1 du circuit 40 sur laquelle est appliqué le signal IN, et la sortie S1 du circuit 40 sur laquelle est produit le signal INN. N est un nombre entier supérieur ou égal à 2.

La première branche de rang n = 0 comprend un premier générateur de potentiel GP1 commandé par le signal IN : il produit un potentiel VDD1 compris entre GND et VDD lorsqu'il reçoit un signal IN actif à GND et il produit un potentiel égal à GND lorsqu'il reçoit le signal IN inactif à VDD. Le générateur de potentiel GP1 comprend un transistor T42 de type P, un circuit de chute de potentiel VD43 et un transistor T44 de type N. Le potentiel VDD est appliqué sur la source de T42 dont le drain est connecté à une entrée du circuit VD43 et dont une sortie au drain de T44 dont la source est connectée à la masse du circuit (potentiel GND). La grille commune des transistors T42, T44 forme une entrée de commande du générateur GP1 et elle est connectée à l'entrée E1 du circuit 40 ; le point commun du circuit de chute de potentiel VD43 et du transistor T44 forme une sortie du générateur GP1 et il est connecté à la sortie S1 du circuit 40.

Le circuit de chute de potentiel VD43 est dimensionné de sorte à entraîner une chute de potentiel VC1 telle que, lorsque le transistor T42 est passant, le potentiel VDD1 en sortie du circuit VD43 est égal à VDD1 = VDD - VC1. Le circuit VD43 est par exemple un transistor monté en diode (cf. le transistor T33 dans l'exemple de la figure 2), une diode, une résistance électrique, etc., en d'autre termes, tout circuit électrique susceptible d'entraîner une chute de potentiel, en consommant de préférence le moins d'énergie possible.

La deuxième branche de rang n = 1 comprend, associés en série :
- un premier circuit de retard Delay1, qui reproduit sur sa sortie le signal qu'il reçoit sur son entrée mais décalé d'un temps Δ1.
- un deuxième générateur de potentiel GP2 commandé par le signal produit par le circuit Delay1 : le générateur GP2 produit un potentiel VDD2 compris entre VDD1 et VDD lorsqu'il reçoit un signal actif à GND (= le signal IN décalé dans le temps de Δ1).

Un circuit de retard connu est réalisé par exemple par un nombre pair d'inverseurs associés en série.

Le deuxième générateur de potentiel GP2 est similaire au premier générateur GP1 ; le générateur GP2 comprend un transistor T45 de type P, un circuit de chute de potentiel VD46 et un transistor T47 de type N. Le potentiel VDD est appliqué sur la source de T45 dont le drain est connecté à une entrée du circuit VD46 et dont une sortie au drain de T47 dont la source est connectée à la masse du circuit (potentiel GND). La grille commune des transistors T45, T47 forme une entrée de commande du générateur de potentiel et elle est connectée à la sortie du circuit Delay1 ; le point commun du circuit de chute de potentiel VD46 et du transistor T47 forme une sortie du générateur de potentiel GP1 et il est connecté à la sortie S1 du circuit 40. Le circuit VD46 introduit une chute de potentiel VC2 entre le drain de T45 et la source de T47 telle que VDD2 = VDD - VC2.

Les branches de rang n = 2 à n = N-1 sont réalisées de manière similaire à la branche de rang n = 1. Elles se distinguent l'une de l'autre simplement par le retard introduit par leur circuit de retard et par le potentiel qu'elles produisent en sortie. Ainsi, la branche de rang n (n variant entre 2 et N-1) comprend, associés en série:
- un circuit de retard Delay_n, qui reproduit sur sa sortie le signal IN qu'il reçoit sur son entrée mais décalé d'un temps Δn compris entre Δn-1 (retard dans la branche de rang n-1) et Δn+1 (retard dans la branche n+1).
- un générateur de potentiel GP_n+1 commandé par le signal produit par le circuit Delay_n : lorsqu'il reçoit un signal actif à GND, le générateur GPn produit un potentiel VDDn compris entre VDD_n (potentiel produit par la branche de rang n-1) et VDD_n+2 (potentiel produit par la branche de rang n+1).

Enfin, la dernière branche de rang n = N comprend, associés en série:
- un circuit de retard Delay_N, qui reproduit sur sa sortie le signal qu'il reçoit sur son entrée mais décalé d'un temps ΔN supérieur à ΔN-1.
- un transistor T51 de type P, ayant un drain connecté à la sortie S1, une grille connectée à la sortie du circuit Delay_N et une source sur laquelle est appliqué le potentiel VDD. T51 forme un générateur GPN d'un potentiel égal à VDD, générateur commandé par le signal logique produit par le circuit Delay_N.

Le fonctionnement du circuit 40 est le suivant.

Lorsque le signal IN appliqué sur l'entrée E1 passe de GND ("0" logique) à VDD ("1" logique), le transistor T42 se bloque et le transistor T44 devient rapidement passant : ce dernier amène le signal INN au potentiel GND. Au bout du temps Δ1 introduit par le circuit Delay1, le transistor T45 se bloque et T47 devient passant, au bout du temps ΔN-1, T48 se bloque et T50 devient passant, ..., au bout du temps ΔN, T51 se bloque.

Inversement, lorsque le signal IN passe de VDD à GND, le transistor T44 se bloque et le transistor T42 devient passant rapidement (temps de basculement des transistors de l'ordre de 2 ns). Le potentiel INN au point S1 est tiré vers VDD1 = VDD - VC1 où VC1 est la chute de potentiel introduite par le circuit VD43.

Puis, au bout du temps Δ1 introduit par le circuit Delay1, le signal sur la grille du transistor T45 passe également à GND : T45 devient passant et T47 se bloque. Le courant circulant dans le transistor T45 et dans le circuit VD46 tire le potentiel du point S1 à VDD2 = VDD - VC2, VC2 (inférieur à VC1) étant la chute de potentiel dans le circuit VD46.

Au bout du temps ΔN-1 introduit par le circuit Delay_N-1, le signal sur la grille du transistor T48 passe également à GND : T48 devient passant et T50 se bloque. Le courant circulant dans le transistor T48 et dans le circuit VD49 tire le potentiel du point S1 à VDD_N = VDD - VCN, VCN (inférieur à VCN-1) étant compris entre 0 et VCN-1.

Enfin, au bout du temps ΔN introduit par le circuit Delay_N, le signal sur la grille du transistor T51 passe également à GND : le transistor T51 devient passant et le courant qui le traverse tire le potentiel du signal INN à VDD.

En résumé, lorsque le signal IN passe de VDD à GND, le signal INN passe rapidement de GND à VDD1 = VDD - VC1, puis à VDD2 = VDD - VC2 au bout du temps Δ1, puis à VDD3 = VDD - VC3 au bout du temps Δ2, ..., puis à VDD_N = VDD - VCN au bout du temps ΔN-1, et enfin à VDD au bout du temps ΔN.

Ainsi, lorsque IN passe de VDD à GND, le signal INN passe de GND à VDD en N+1 étapes, et en passant successivement et par des paliers intermédiaires VDD1, VDD2, ..., VDD_N, de niveaux croissants progressivement au fil du temps.

Les variations progressives du signal INN vont entraîner une augmentation progressive (N+1 pentes successives d'importances croissantes) du courant de décharge circulant dans le transistor T22 et en conséquence des variations également progressives des pentes du potentiel OUT. Le potentiel OUT est ainsi lissé encore plus efficacement que dans le cas du circuit de la figure 2, ce qui limite encore les perturbations électromagnétiques.

A titre d'exemple illustratif, on a représenté sur la figure 4, lorsque IN passe de VDD à GND :
- les variations en fonction du temps des signaux INN et OUT (courbes A, B en pointillés) dans le circuit connu de la figure 1
- les variations en fonction du temps des signaux INN, OUT (courbes C, D en trait plein) dans le cas d'un circuit selon l'invention, plus précisément conforme au circuit de la figure 3, avec N = 3.

Sur la courbe A, le signal INN a la forme d'un créneau de potentiel : INN passe directement de GND à VDD, très rapidement avec une phase transitoire (temps pendant lequel INN varie) de très courte durée. Puis INN est constant à VDD entre t = 0 et t = ΔN.

Sur la courbe B, le signal OUT correspondant suit les variations du signal INN de la courbe A : OUT est nul jusqu'à t = 0, OUT décroît linéairement depuis VPP jusqu'à 0 entre t = 0 et t = ΔN, selon une pente constante proportionnelle à INN, et donc proportionnelle à VDD.

Sur la courbe C, le signal INN a la forme d'un escalier : il augmente progressivement et lentement de 0 à VDD en passant par des paliers intermédiaires de valeurs VDD1, VDD2, VDD3 croissantes.

Sur la courbe D, le signal OUT suit les variations du signal INN de la courbe C : le signal OUT décroît, sous la forme de quatre portions de droite ayant des pentes proportionnelles respectivement à VDD1, VDD2, VDD3 et VDD, c'est-à-dire des pentes qui augmentent. On voit clairement que cette courbe présente des changements de pentes aux instants t = 0, Δ1, Δ2, Δ3 : ces changements sont d'amplitude plus faible que l'amplitude du changement de pente de la courbe B à l'instant t = 0.

Le circuit selon l'invention permet ainsi de modifier lentement la pente du signal de sortie OUT, en plusieurs étapes correspondant aux paliers par lesquels passe le signal INN.

De tels changements d'amplitude limités de la pente du signal OUT limitent les rayonnements électromagnétiques apparaissant aux moments des changements de pente.

Dans l'exemple de la figure 4, on a choisi N = 4. L'expérience montre que la courbe idéale pour le potentiel OUT, c'est-à-dire celle entraînant le moins de rayonnements électromagnétiques, est une sinusoïde, dont on peut se rapprocher en utilisant une grande valeur de N. En pratique, le choix de N sera un compromis entre des rayonnements électromagnétiques faibles (donc N grand) et la taille globale du circuit de commande, dont le nombre de branches augmente naturellement en fonction de N.

Egalement, dans l'exemple de la figure 4, on a choisi des paliers de potentiels VDD1, VDD2, VDD3 régulièrement répartis entre GND et VDD, et des intervalles de temps Δ1, Δ2, Δ3 régulièrement répartis entre t = 0 et T = Δ4. Bien sûr, toutes les répartitions de paliers de potentiel et d'intervalles de temps sont envisageables et il n'est pas nécessaire qu'elles soient régulières. Le choix sera fait de préférence pour minimiser les rayonnements électromagnétiques, et tiendra compte notamment de la valeur de VDD, de la valeur de Δ4 et des composants électroniques disponibles pour réaliser les circuits de chute de potentiel et les circuits de retard.

## Revendications

1. Circuit de décharge comprenant un circuit de sortie (20, T22) dont une sortie (4) est connectée à une charge électrique (CLoad) pour absorber un courant de décharge fourni par la charge (CLoad) lorsqu'un signal logique (IN) commande une décharge de la charge (CLoad), un circuit de commande (30, 40) pour fournir au circuit de sortie un signal de commande (INN) approprié pour qu'une pente d'un potentiel (OUT) de sortie (4) du circuit de sortie (20, T22) diminue progressivement lorsque le signal logique (IN) commande une décharge de la charge (CLoad), **caractérisé en ce que** le circuit de commande (30, 40) comprend des moyens pour augmenter progressivement un potentiel du signal de commande (INN) lorsque le signal logique (IN) est actif (0), lesdits moyens comprenant N branches connectées en parallèle, N étant un nombre entier supérieur ou égal à 2, chaque branche de rang n comprenant un générateur de potentiel de rang n apte à produire un potentiel (VDDn) de rang n, les potentiels (VDDn) de chaque branche étant fournis comme signal de commande (INN) successivement dans un ordre croissant lorsque le signal logique d'entrée (IN) est actif.

2. Circuit selon la revendication 1, dans lequel le circuit de commande comprend, connectées en parallèle entre une borne d'entrée (E1) sur laquelle est appliqué le signal logique d'entrée (IN) et une borne de sortie (S1) sur laquelle est produit le signal de commande (INN) :
• la première branche comprenant le premier générateur de potentiel produisant le premier potentiel (VDD1) inférieur à un potentiel d'alimentation (VDD) du circuit lorsqu'il reçoit le signal logique (IN) actif,
• la deuxième branche comprenant le deuxième générateur de potentiel produisant le potentiel d'alimentation (VDD) lorsqu'il reçoit le signal logique retardé d'un premier retard (Δ1).

3. Circuit selon la revendication 2, dans lequel le premier générateur de potentiel comprend :
• un circuit de chute de potentiel, pour produire un potentiel intermédiaire (VDD1) lorsqu'il reçoit le potentiel d'alimentation,
• des moyens interrupteurs (T32, T34) pour appliquer le potentiel d'alimentation (VDD) sur l'entrée du circuit de chute de potentiel (T33) lorsque le signal logique (IN) est actif, ou pour relier la sortie du circuit de chute de potentiel à la masse lorsque le signal logique (IN) est inactif.

4. Circuit selon la revendication 3, dans lequel le circuit de chute de potentiel est une diode, un transistor (T33) ou une résistance.

5. Circuit selon l'une des revendications 3 ou 4, dans lequel les moyens interrupteurs sont un ou plusieurs transistors (T32, T34) commandés par le signal logique.

6. Circuit selon l'une des revendications 2 à 5, dans lequel le deuxième générateur de potentiel comprend un transistor comprenant un drain sur lequel est appliqué le potentiel d'alimentation (VDD), une source connectée à la sortie du circuit de commande et une grille de commande connectée à l'entrée du circuit de commande.

7. Circuit selon la revendication 1, dans lequel chaque générateur de rang n reçoit le signal d'entrée (IN) retardé d'un retard de rang i (Delay_n), n étant un nombre entier variant entre 1 et N,
le potentiel de rang n étant :
• supérieur au potentiel de rang n-1 immédiatement inférieur et
• inférieur au potentiel de rang n+1 immédiatement supérieur,
• le générateur de potentiel de la branche de rang N produisant le potentiel d'alimentation (VDD),
le retard de rang n étant :
• supérieur au retard de rang n-1 immédiatement inférieur, et
• inférieur au retard de rang n+1 immédiatement supérieur,
• le retard dans la branche de rang n = 1 étant nul.

8. Etage de sortie de puissance, pour la commande d'une charge (CLoad), l'étage de sortie comprenant un circuit de charge (10, T21) pour fournir à la charge (CLoad) un courant de charge lorsqu'un signal logique commande une charge de la charge (CLoad),
**caractérisé en ce qu'**il comprend également un circuit de décharge selon l'une des revendications précédentes.

9. Ecran de visualisation comprenant au moins une cellule de type capacitif pour créer un point lumineux sur l'écran, et un circuit d'adressage pour produire un signal logique de commande de la cellule,
**caractérisé en ce qu'**il comprend également un étage de sortie selon la revendication 8, pour commander la cellule à partir du signal logique de commande.

10. Ecran selon la revendication précédente, de type écran plasma ou écran plat.

## Claims

1. Discharge circuit comprising an output circuit (20, T22) an output (4) of which is connected to an electrical load (CLoad) to absorb a discharge current supplied by the load (CLoad) when a logical signal (IN) commands a discharge of the load (CLoad), a control circuit (30, 40) to supply to the output circuit an appropriate control signal (INN) so that a slope of an output potential (OUT) (4) of the output circuit (20, T22) drops gradually when the logical signal (IN) commands a discharge of the load (CLoad) **characterised in that** the control circuit (30, 40) comprises means to gradually increase a potential of the control signal (INN) when the logical signal (IN) is active (0), the said means comprising N branches connected in parallel, N being an integer greater than or equal to 2, each branch of rank n comprising a potential generator of rank n capable of producing a potential (VDDn) of rank n, the potentials (VDDn) of each branch being supplied as control signals (INN) successively in increasing order when the logical input signal (IN) is active.

2. Circuit according to claim 1 where the control circuit comprises, connected in parallel between an input terminal (E1) to which the logical input signal (IN) is applied and an output terminal (S1) on which the control signal (INN) is produced:
• the first branch comprising the first potential generator producing the first potential (VDD 1) lower than a power supply potential (VDD) of the circuit when it receives the active logical signal (IN),
• the second branch comprising the second potential generator producing the power supply potential (VDD) when it receives the logical signal delayed by a first delay (Δ1).

3. Circuit according to claim 2 where the first potential generator includes:
• a potential drop circuit to produce an intermediary potential (VDD1) when it receives the power supply potential,
• switching means (T32, T34) to apply the power supply potential (VDD) to the input of the potential drop circuit (T33) when the logical signal (IN) is active or to connect the output of the potential drop circuit to the ground when the logical signal (IN) is inactive.

4. Circuit according to claim 3 where the potential drop circuit is a diode, a transistor (T33) or a resistor.

5. Circuit according to one of the claims 3 or 4 where the switching means are one or more transistors (T32, T34) controlled by the logical signal.

6. Circuit according to one of the claims 2 to 5 where the second potential generator comprises a transistor comprising a drain to which the power supply potential (VDD) is applied, a source connected to the output of the control circuit and a control grid connected to the input of the control circuit.

7. Circuit according to claim 1 where each generator of rank n receives the input signal (IN) delayed by a delay of rank i (Delay_n), n being an integer varying between 1 and N, the potential of rank n being:
• higher than the potential of immediately lower rank n-1 and
• lower than the potential of immediately higher rank n+1,
• the potential generator of the branch of rank N producing the power supply potential (VDD),
the delay of rank n being:
• higher than the delay of immediately lower rank n-1 and
• lower than the delay of immediately higher rank n+1,
• the delay in the branch of rank n = 1 being null.

8. Power output stage for controlling a load (CLoad), the output stage comprising a load circuit (10, T21) to supply to the load (CLoad) a charge current when a logical signal commands a charge of the load (CLoad),
**characterised in that** it also includes a discharge circuit according to one of the previous claims.

9. Display screen comprising at least one cell of capacitive type to create a luminous point on the screen and an addressing circuit to produce a logical control signal of the cell,
**characterised in that** it also comprises an output stage according to claim 8 to control the cell from a logical control signal.

10. Screen according to the previous claim of plasma screen or flat screen type.

## Patentansprüche

1. Entladeschaltung, umfassend einen Ausgangsstromkreis (20, T22), dessen Ausgang (4) an eine elektrische Last (CLoad) angeschlossen ist, um einen Entladestrom aufzunehmen, der von der Last (CLoad) bereitgestellt wird, wenn ein logisches Signal (IN) eine Entladung der Last befiehlt, einen Steuerstromkreis (30, 40) für die Versorgung des Ausgangsstrormkreises mit einem Steuersignal (INN), das geeignet ist, damit ein Spannungsgefälle (OUT) des Ausgangs (4) des Ausgangsstromkreises (20, T22) fortschreitend abnimmt, wenn das logische Signal (IN) eine Entladung der Last (CLoad) befiehlt, **dadurch gekennzeichnet, dass** der Stromsteuerkreis (30, 40) Mittel umfasst für die fortschreitende Erhöhung einer Spannung des Steuersignales (INN), wenn das logische Signal (IN) aktiv (0) ist, wobei die Mittel N parallelgeschaltete Zweige umfassen, wobei N eine ganze Zahl größer als oder gleich 2 ist, wobei jeder Zweig des Rangs n einen Spannungsgenerator des Rangs n umfasst, der geeignet ist für die Erzeugung einer Spannung (VDDn) des Rangs n, wobei die Spannungen (VDDn) jedes Zweiges als Steuersignal (INN) in aufsteigender Reihenfolge sukzessiv bereitgestellt werden, wenn das logische Eingangssignal (IN) aktiv ist.

2. Schaltung nach Anspruch 1, wobei der Stromsteuerkreis parallelgeschaltet zwischen einer Eingangsklemme (E1), an der das logische Eingangssignal (IN) anliegt, und einer Ausgangsklemme (S1), an der das Steuersignal (INN) erzeugt wird, umfasst:
- den ersten Zweig, umfassend den ersten Spannungsgenerator, der bei Empfang des aktiven logischen Signals (IN) die erste Spannung (VDD1) erzeugt, die kleiner ist als eine Versorgungsspannung (VDD) des Stromkreises,
- den zweiten Zweig, umfassend den zweiten Spannungsgenerator, der bei Empfang des um eine erste Verzögerung (Δ1) verzögerten logischen Signals die Versorgungsspannung (VDD) erzeugt.

3. Schaltung nach Anspruch 2, wobei der erste Spannungsgenerator umfasst:
- eine Spannungsminderungsschaltung, um bei Empfang der Versorgungsspannung eine Zwischenspannung (VDD1) zu erzeugen,
- Unterbrechermittel (T32, T34) zum Anlegen der Versorgungsspannung (VDD) an den Eingang der Spannungsminderungsschaltung (T33), wenn das logische Signal (IN) aktiv ist, oder zur Verbindung des Ausgangs der Spannungsminderungsschaltung mit der Masse, wenn das logische Signal (IN) inaktiv ist.

4. Schaltung nach Anspruch 3, wobei die Spannungsminderungsschaltung eine Diode, ein Transistor (T33) oder ein Widerstand ist.

5. Schaltung nach einem der Ansprüche 3 oder 4, wobei die Unterbrechermittel ein oder mehrere Transistoren (T32, T34) sind, die durch das logische Signal gesteuert werden.

6. Schaltung nach einem der Ansprüche 2 bis 5, wobei der zweite Spannungsgenerator einen Transistor umfasst, der einen Drain aufweist, an dem die Versorgungsspannung (VDD) anliegt, eine mit dem Ausgang des Stromsteuerkreises verbundene Source und ein Steuergate, das mit dem Eingang des Stromsteuerkreises verbunden ist.

7. Schaltung nach Anspruch 1, wobei jeder Generator des Rangs n das Eingangssignal (IN) um eine Verzögerung des Rangs i (Delay_n) verzögert empfängt, wobei n eine ganze Zahl zwischen 1 und N ist, wobei die Spannung des Rangs n
- größer ist als die Spannung des unmittelbar darunterliegenden Rangs n-1 und
- kleiner als die Spannung des unmittelbar darüberliegenden Rangs n+1,
- der Spannungsgenerator des Zweiges des Rang N die
Versorgungsspannung (VDD) erzeugt,
wobei die Verzögerung des Rangs n
- größer ist als die Verzögerung des unmittelbar darunterliegenden Rangs n-1
- kleiner als die Verzögerung des unmittelbar darüberliegenden Rangs n+1
- die Verzögerung in dem Zweig des Rangs n = 1 Null ist.

8. Leistungsausgangsstufe für die Steuerung einer Last (CLoad), wobei die Ausgangsstufe eine Ladeschaltung (10, T21) umfasst für die Versorgung einer Last (CLoad) mit einem Ladestrom, wenn ein logisches Steuersignal ein Laden der Last (CLoad) befiehlt, **dadurch gekennzeichnet, dass** die Leistungsausgangsstufe auch eine Entladeschaitung gemäß einem der vorhergehenden Ansprüche umfasst.

9. Anzeigeschirm, umfassend wenigstens eine Zelle des kapazitiven Typs, um auf dem Schirm eine Lichtmarke zu schaffen, und eine Adress-Schaltung zur Erzeugung eines logischen Signals für die Steuerung der Zelle, **dadurch gekennzeichnet, dass** der Anzeigeschirm auch eine Ausgangsstufe gemäß Anspruch 8 umfasst, um die Zelle ausgehend von dem logischen Steuersignal zu steuern.

10. Schirm nach dem vorhergehenden Anspruch, entsprechend dem Typ eines Plasmabildschirms oder eines Flachbildschirms.
